# EUROPÄISCHE PATENTSCHRIFT

(11) **EP 0 340 445 B1**
(45) Veröffentlichungstag und Bekanntmachung des Hinweises auf die Patenterteilung: **25.08.1993**
(21) Anmeldenummer: 89105333.2
(22) Anmeldetag: 25.03.1989
(51) Int. Cl.: H01L 29/74

(54) **Abschaltbares Leistungshalbleiterbauelement**
Turn-off power semiconductor device
Dispositif semi-conducteur de puissance, à extinction

(30) Priorität: 22.04.1988 CH 1520/88
(43) Veröffentlichungstag der Anmeldung: 08.11.1989
(73) Patentinhaber: ASEA BROWN BOVERI AG, 5400 Baden (CH)
(72) Erfinder: Bauer, Friedhelm, Dr., D-5303 Würenlingen (CH)

(56) Entgegenhaltungen:
- EP-A- 0 118 007
- EP-A- 0 219 995
- INTERNATIONAL ELECTRON DEVICES MEETING, Washington D.C., 8.-10. Dezember 1980, Seiten 79-82, IEEE, New York, US; L. LEIPOLD et al.: "A FET-controlled thyristor in SIPMOS technology"
- IEEE TRANSACTIONS ON ELECTRON DEVICES, Band ED-33, Nr. 10, Oktober 1986, Seiten 1609-1618, IEEE, New York, US; V.A.K. TEMPLE: "MOS-controlled thyristors-A new class of power devices"
- PATENT ABSTRACTS OF JAPAN, Band 12, Nr. 498 (E-698)[3345], 26. Dezember 1988, Seite 89 E 698; & JP-A-63 209 172 (TOSHIBA CORP.) 30-08-1988

## Beschreibung

### Technisches Gebiet

Die vorliegende Erfindung bezieht sich auf das Gebiet der Leistungselektronik. Sie betrifft insbesondere ein abschaltbares Leistungshalbleiter-Bauelement nach dem Oberbegriff des ersten Anspruchs.

### STAND DER TECHNIK

Seit einigen Jahren ist in der Leistungselektronik zunehmend die Entwicklung von MOS-gesteuerten Bauelementen vorangetrieben worden. Eingeleitet wurde dieser Trend von den unipolaren Leistungs-MOSFETs mit DMOS-Struktur.

Der Vorteil dieser MOS-gesteuerten Bauelemente liegt hauptsächlich in der hohen Eingangsimpedanz an der Steuerelektrode begründet. Sie ermöglicht die Ansteuerung des Bauelements mit einem vergleichsweise sehr geringen Aufwand an Leistung.

Die DMOSFETs haben jedoch einen gewichtigen Nachteil: Hohe Durchbruchsspannungen müssen bei diesen Bauelementen wegen des unipolaren Leitungscharakters mit hohen Durchlasswiderständen erkauft werden, welche die maximale Stromstärke begrenzen.

Seit kurzer Zeit ist für dieses Problem mit dem IGBT (Insulated Gate Bipolar Transistor) eine Lösung verfügbar (siehe dazu: B.J. Baliga et al., IEEE Trans. Electron Devices, ED-31, S. 821-828 (1984)).

Der IGBT verfügt über eine Kathodenstruktur, die der des DMOSFET weitgehend ähnelt. Er kann vereinfacht als eine Kaskadenschaltung aus einem DMOSFET und einem Bipolartransistor aufgefasst werden. Infolge des bipolaren Stromtransports in der hochohmigen n-Basisschicht ist dieser Bereich leitfähigkeitsmoduliert; damit kann auch bei Bauelementen mit hoher Sperrspannung ein kleiner Wert für den Durchlasswiderstand realisiert werden.

Diese IGBTs verwenden L. Leipold et al. im Artikel "A FET Controlled Thyristor in SIPMOS Technology", Technical Digest of International Electron Devices Meeting 1980, Seiten 79-82, zum Einschalten eines Thyristors . Sie verwenden einen IGBT-Transistor, welcher den für das Zünden des Thyristors benötigten Strom intern generiert. Zu diesem Zweck werden den Thyristorzellen IGBT-Zellen parallelgeschaltet. Bei diesem Bauteil handelt es sich jedoch immer noch um einen herkömmlichen Thyristor, welcher nicht aktiv ausgeschaltet werden kann.

Ein anderer Weg wurde in der EP-A-0 219 995 beschritten. Nach dieser Druckschrift werden MOSFETs sowohl für das Ein- wie für das Ausschalten eines GTO verwendet. Die Ein- bzw. Ausschalt-MOSFETs werden über zwei getrennte Steuerelektroden angesteuert.

Es ist nun weiterhin vorgeschlagen worden, das beschriebene Konzept der Steuerung von Leistungshalbleiter-Bauelementen über MOS-Gates auch bei Bauelementen der höchsten Leistungsklasse, nämlich bei Thyristoren, zu verwirklichen (siehe dazu den Artikel von V.A.K. Temple, IEEE Trans. Electron Devices, ED-33, S. 1609-1618 (1986)).

Bei einem derartigen MOS-gesteuerten Thyristor oder MCT (MOS Controlled Thyristor), der aus einer Vielzahl von nebeneinanderliegenden, parallelgeschalteten Einheitszellen besteht, wird das Abschalten über einen Kurzschluss des Emitters mit der p-Basis durch schaltbare Emittershorts erreicht. Als Schalter dienen dabei mit dem Emitter integrierte MOSFETs, die naturgemäss wahlweise als n- oder p-Kanal-MOSFETs ausgebildet sein können.

Im Hinblick auf eine einfache Schaltungstechnik ist es natürlich wünschenswert, mit Hilfe der MOS-Gates den Thyristor nicht nur aus- sondern auch einzuschalten. Dies sollte nach Möglichkeit mit einer einzigen Steuerelektrode erreichbar sein.

Eine Struktur, welche diese Anforderungen erfüllt, ist in dem Artikel von V.A.K. Temple bereits vorgeschlagen worden (dortige Fig. 5). Es handelt sich dabei um eine kombinierte Ein- und Ausschaltzelle, bei der innerhalb der ursprünglichen MCT-Einheitszelle eine weitere DMOS-Struktur benutzt wird, um über einen Kanal in der zur Substratoberfläche hochgezogenen p-Basisschicht Elektronen in die n-Basisschicht zu injizieren.

Diese bekannte kombinierte Ein- und Ausschaltzelle wirft jedoch zwei Probleme auf:
Der Kanal des zum Einschalten verwendeten DMOSFET wird von der an die Oberfläche gezogenen p-Basisschicht gebildet. Für typische Thyristoren bewegt sich die Tiefe dieser p-Basisschicht im Bereich von wenigstens 20 Mikrometern. Dieses Mass entspricht dann auch in etwa der Kanallänge des DMOSFETs. Es ist damit erheblich grösser als die typischen Kanallängen von IGBTs, welche bei ungefähr 1 Mikrometer liegen. Wegen der grossen Kanallänge werden weniger Elektronen in die n-Basisschicht injiziert, wodurch beim Einschalten der effiziente Aufbau eines Plasmas behindert und die Einschaltzeit verlängert wird.

Andererseits hat die Verwendung von kombinierten Ein- und Ausschaltzellen zur Folge, dass höchstens genausoviele Einschalt- wie Ausschaltelemente im Bauelement vorhanden sind. Es fehlt daher die Möglichkeit, Anzahl und Verteilung dieser Elemente unabhängig voneinander im Hinblick auf die an das Bauelement gestellten Anforderungen zu optimieren.

### Darstellung der Erfindung

Aufgabe der vorliegenden Erfindung ist es nun, ein abschaltbares Leistungshalbleiter-Bauelement zu schaffen, das sich durch verbesserte Schalteigenschaften auszeichnet und zugleich einfacher optimiert werden kann.

Diese Aufgabe wird durch die Merkmale des ersten Anspruchs gelöst.

Der Kern der Erfindung besteht also darin, die bisherigen kombinierten Ein- und Ausschaltzellen durch zwei getrennte, parallelgeschaltete MCT- und IGBT-Einheitszellen zu ersetzen.

Auf diese Weise kann die für das Einschalten verantwortliche IGBT-Einheitszelle bezüglich ihrer Kanallänge optimal ausgelegt werden. Darüber hinaus können die IGBT-Einheitszellen im eingeschalteten Zustand einen Teil des Durchlassstroms übernehmen und die MCT-Einheitszellen beim Abschalten in ihrer Funktion unterstützen. Schliesslich können mehr IGBT- als MCT-Einheiten vorgesehen werden, um einer Bildung von Stromfilamenten im Bauelement vorzubeugen.

In gleicher Weise kann auch ein komplementäres Bauelement verwirklicht werden, bei dem in der MCT-Einheitszelle n-Kanal-MOSFETs und in der IGBT-Einheitszelle p-Kanal-MOSFETs Verwendung finden.

Weitere Ausführungsformen ergeben sich aus den Unteransprüchen.

### KURZE BESCHREIBUNG DER ZEICHNUNG

Die Erfindung soll nachfolgend anhand von Ausführungsbeispielen im Zusammenhang mit der Zeichnung näher erläutert werden. Es Zeigen:
- Fig. 1: eine MCT-Einheitszelle eines MOS-gesteuerten Thyristors nach dem Stand der Technik;
- Fig. 2: eine kombinierte Ein- und Ausschaltzelle eines MOS-gesteuerten Thyristors nach dem Stand der Technik; und
- Fig. 3: ein Ausführungsbeispiel für eine nebeneinanderliegende MCT- und IGBT-Einheitszelle nach der Erfindung.

### WEGE ZUR AUSFÜHRUNG DER ERFINDUNG

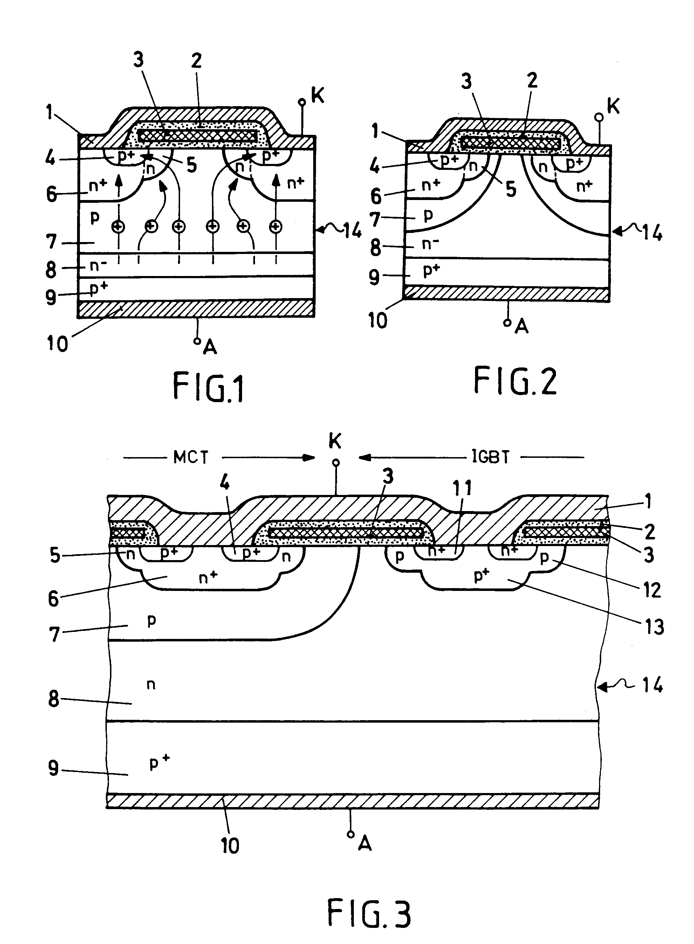

In Fig. 1 ist im Querschnitt die MCT-Einheitszelle eines MOS-gesteuerten Thyristors gezeigt, wie sie aus Fig. 3b der genannten Druckschrift von V.A.K. Temple bekannt ist.

In dieser Einheitszelle sind zwischen einer Anode A und einer Kathode K in einem Halbleitersubstrat 14 mehrere unterschiedlich dotierte Schichten in einer Schichtfolge angeordnet. Die Schichtfolge umfasst eine p⁺-dotierte p-Emitterschicht 9, eine n⁻-dotierte n-Basisschicht 8, eine p-dotierte p-Basisschicht 7 und ein n⁺-dotiertes n-Emittergebiet 6 mit seitlich angrenzenden n-dotierten Kanalgebieten 5 und eingelagerten, p⁺-dotierten Sourcegebieten 4.

Das n-Emittergebiet 6 tritt zwischen den eingelagerten Sourcegebieten 4 an die kathodenseitige Oberfläche des Halbleitersubstrats 14 und wird dort von einem Kathodenkontakt 1 in Form einer Metallisierung kontaktiert. p-Emitterschicht 9, n-Basisschicht 8, p-Basisschicht 7 und n-Emittergebiet 6 bilden in diesem Bereich eine herkömmliche pnpn-Thyristorstruktur.

Das Abschalten des Thyristors wird durch Einschalten von MOS-gesteuerten Kurzschlüssen auf der Kathodenseite bewirkt, welche die p-Basisschicht 7 mit dem Kathodenkontakt 1 kurzschliessen.

Zu diesem Zweck treten die Sourcegebiete 4, die Kanalgebiete 5 und die p-Basisschicht 7 nebeneinander an die kathodenseitige Substratoberfläche und bilden dort jeweils einen p-Kanal-MOSFET, der durch eine darüberliegende, mittels einer Gateisolierung 2 isolierte Gateelektrode 3 gesteuert wird.

Ist der Thyristor eingeschaltet, fliessen die aus der p-Emitterschicht 9 in die p-Basisschicht injizierten Löcher (in Fig. 1 als Kreise eingezeichnet) über das n-Emittergebiet 6 zur Kathode K ab.

Sobald die Gateelektrode 3 hinreichend negativ vorgespannt wird, bilden sich in den Kanalgebieten 5 unterhalb der Substratoberfläche p-leitende Inversionskanäle, die wegen der höheren Leitfähigkeit den Hauptteil des Löcherstromes übernehmen und damit den Strom im Thyristorgebiet unter das Niveau des Haltestroms senken: Der Thyristor schaltet ab.

Der in Fig. 1 gezeigte Aufbau bezieht sich lediglich auf den Abschaltmechanismus des Thyristors. Zum Einschalten müssen daher zusätzliche Massnahmen vorgesehen werden. Eine Massnahme, die ebenfalls aus dem genannten Artikel von V.A.K. Temple bekannt ist, soll anhand der Fig. 2 erläutert werden.

In dieser Figur ist die Einheitszelle gemäss Fig. 1 dahingehend erweitert, dass sie neben der Abschalt- auch die Einschaltfunktion übernimmt, d.h. eine kombinierte Ein- und Ausschaltzelle darstellt.

Die zusätzliche Funktion des Einschaltens wird dadurch realisiert, dass die p-Basisschicht 7 und die n-Basisschicht 8 unterhalb der Gateelektrode 3 bis zur kathodenseitigen Substratoberfläche hochgezogen sind. Die oberflächennahen Bereiche der p-Basisschicht 7 bilden dann ebenfalls ein Kanalgebiet und zusammen mit dem benachbarten Kanalgebiet 5 und der n-Basisschicht 8 jeweils einen n-Kanal-MOSFET.

Sobald die Gateelektroden hinreichend positiv vorgespannt werden, werden die n-Kanäle dieser zweiten MOSFETs leitend. Damit gelangen Elektronen in die n-Basisschicht 8 und bewirken ihrerseits die Injektion von Löchern aus der p-Emitterschicht 9. Die p-Kanäle der ersten MOSFETs in den Kanalgebieten 5 sind bei dieser Gatevorspannung nicht-leitend. Die Kurzschlüsse sind also ausgeschaltet und der Thyristor befindet sich deshalb in einem Zustand maximaler Zündbereitschaft, so dass sich das initiierte Plasma ungehindert ausbreiten und den Thyristor in den Durchlasszustand bringen kann.

Wie aus dieser Schilderung zu entnehmen ist, hängt der Zündvorgang massgeblich von den Eigenschaften der n-Kanäle ab, über die Elektronen in die n-Basisschicht 8 gelangen. Um eine gute Zündung zu erreichen, sollten daher die n-Kanäle einen möglichst geringen Widerstand, d.h. bei vorgegebener Leitfähigkeit eine möglichst geringe Länge, aufweisen.

Diese Bedingung kann bei dem in Fig. 2 dargestellten Aufbau jedoch nur unvollkommen erfüllt werden, weil die Länge der dortigen n-Kanäle nicht unabhängig optimiert werden kann, sondern massgeblich von der relativ grossen Tiefe der p-Basisschicht 7 mitbestimmt wird.

Gemäss der Erfindung wird daher ein vollkommen anderer Weg beschritten: Die Ein- und Ausschaltfunktion wird nicht länger von einer kombinierten Einheitszelle ausgeübt, sondern der MCT-Einheitszelle nach Fig. 1 wird eine andere Einheitszelle parallelgeschaltet, die eine IGBT-Struktur aufweist, wie sie aus dem Artikel von B.J. Baliga et al. bekannt ist.

Eine bevorzugte Ausführungsform eines solchen Bauelements mit zwei unterschiedlichen Einheitszellen ist in Fig. 3 dargestellt.

Der linke Teil der in Fig. 3 gezeigten Struktur bildet die aus Fig. 1 bekannte MCT-Einheitszelle mit den MOS-gesteuerten Kurzschlüssen. Diese MCT-Einheitszelle ist im wesentlichen für den Ausschaltvorgang verantwortlich.

Der rechte Teil der Struktur bildet eine an sich bekannte IGBT-Einheitszelle. Die p-Emitterschicht 9 und die n-Basisschicht 8 sind dabei als durchgehende Schichten ausgebildet. Die p-Basisschicht 7 ist ausserhalb der MCT-Einheitszelle zur Oberfläche hingezogen, was einfach durch eine maskierte Implantation und eine anschliessende Diffusion erreicht werden kann.

Die IGBT-Einheitszelle enthält neben der p-Emitterschicht 9 und der n-Basisschicht 8 noch einen p⁺-Bereich 13 mit seitlich angrenzenden, p-dotierten Kanalgebieten 12 und eingelagerten, n⁺-dotierten Sourcegebieten 11, die zusammen mit den Kanalgebieten 12 und der n-Basisschicht 8 jeweils n-Kanal-MOSFETs bilden.

Das Einschalten des Thyristors wird durch die IGBT-Einheitszelle gewährleistet. Die Gateelektroden 3 liegen dabei vorzugsweise alle auf demselben Potential, so dass benachbarte MCT- und IGBT-Einheitszellen sogar (wie in Fig. 3 dargestellt) mit denselben Gateelektroden angesteuert werden können.

Die Funktion der IGBT-Einheitszelle ist die folgende: Die IGBT-Struktur ist ein Element vom n-Kanal-Typ. Wird daher die zugehörige Gateelektrode 3 hinreichend positiv vorgespannt, wird der n-Kanal leitend und es läuft im Prinzip derselbe Mechanismus ab, wie er beim Zündvorgang der Struktur aus Fig. 2 beschrieben worden ist.

Beim Abschalten mit negativer Gatevorspannung werden in bekannter Weise die Kurzschlüsse in der MCT-Einheitszelle eingeschaltet und die n-Kanäle in der IGBT-Einheitszelle gesperrt, so dass der Haltestrom sicher unterschritten wird.

Die Vorteile der Anordnung aus Fig. 3 gegenüber der aus Fig. 2 ergeben sich aus folgender Ueberlegung: Die Grundstruktur aus Fig. 2 besteht aus dem n-Emittergebiet 6, das lokal in die p-Basisschicht 7 eingebettet ist. Das n-Emittergebiet 6 enthält weiterhin die Sourcegebiete 4 sowie die Kanalgebiete 5, die den Kanal der p-Kanal-MOSFETs zum Schalten der Kurzschlüsse repräsentieren.

Die Kanalgebiete 5 stellen ihrerseits die Sourcegebiete für die n-Kanal-MOSFETs zum Zünden des Thyristors dar. Der Kanal wird in diesem Fall von der an die Oberfläche gezogenen p-Basisschicht 7 gebildet. Wie bereits bemerkt, funktioniert diese Struktur in der gleichen Weise wie die Kombination aus MCT- und IGBT-Einheitszelle gemäss Fig. 3.

Für typische Thyristoren dürfte sich die Tiefe der p-Basisschicht 7 im Bereich von wenigstens 20 Mikrometern bewegen. Es ist klar, dass dieses Mass dann auch in etwa der Kanallänge der n-Kanal-MOSFETs entspricht.

Die Kanallänge ist damit erheblich grösser als die typische Kanallänge von IGBTs, welche etwa bei 1 Mikrometer liegen. Es ist hier wichtig, festzustellen, dass durch diesen Umstand der IGBT mehr Elektronen in die Basis injiziert als die Struktur gemäss Fig. 2. Die wichtige Folge hiervon ist ein erheblich effizienterer Aufbau des Plasmas. Wegen der bekannt kurzen Einschaltzeit des IGBT wird schon nach kurzen Zeiten hinreichend Plasma zur Verfügung gestellt, um das gesamte Bauelement sicher zu zünden.

Bei der vorgeschlagenen MCT-IGBT-Kombination handelt es sich um die Realisierung einer Parallelschaltung beider Komponenten. Dementsprechend kann die IGBT-Einheitszelle einen Teil des Durchlassstroms übernehmen.

Wichtiger ist noch, dass der IGBT beim Abschalten eine wesentliche, aktive Rolle spielen kann. Diese besteht darin, aus der n-Basisschicht 8 Löcher abzuziehen und so den Abschaltvorgang des MCT zu unterstützen.

Dieser Umstand kann auch zur Lösung einer Problematik herangezogen werden, die beim MCT auftritt, nämlich der Bildung von Stromfilamenten beim Abschalten. Da beim erfindungsgemässen Bauelement MCT- und IGBT-Einheitszellen unabhängig voneinander in ungleicher Anzahl und Verteilung vorgesehen werden können, ist es möglich und vorteilhaft, IGBT- und MCT-Einheitszellen in einem Zahlenverhältnis grösser 2 : 1, vorzugsweise von etwa 3 : 1 einzubauen.

Solche Mischbauelemente sind wegen der grossen Anzahl von IGBT-Einheitszellen frei von Filamentbildung (die beim IGBT nicht auftritt), besitzen andererseits aber wegen der MCT-Einheitzellen einen wesentlich geringeren Durchlasswiderstand als ein reiner IGBT.

Schliesslich sei noch darauf hingewiesen, dass ein solches Bauelement auch in einer zu Fig. 3 komplementären Struktur aufgebaut werden kann als Kombination aus einem n-Kanal-MCT und einem p-Kanal-IGBT.

## Patentansprüche

1. Abschaltbares Leistungshalbleiter-Bauelement, bei welchem
a) in einem Halbleitersubstrat (14) zwischen einer Anode (A) und einer Kathode (K) eine Mehrzahl von ersten Einheitszellen nebeneinander angeordnet und parallelgeschaltet ist;
b) jede dieser ersten Einheitszellen als MOS-gesteuerter Thyristor (MCT = MOS Controlled Thyristor) aufgebaut ist, welcher über einen feldeffektgesteuerten Kurzschluss abgeschaltet werden kann;
c) jede der ersten Einheitszellen zwischen der Anode (A) und der Kathode (K) eine Schichtfolge aus einer p⁺-dotierten p-Emitterschicht, einer n-dotierten n-Basisschicht, einer p-dotierten p-Basisschicht (7) und einem n⁺-dotierten n-Emittergebiet (6) mit seitlich angrenzenden, n-dotierten Kanalgebieten (5) und eingelagerten, p⁺-dotierten Sourcegebieten (4) umfasst;
d) in jeder der ersten Einheitszellen die Sourcegebiete (4), die Kanalgebiete (5) und die p-Basisschicht (7) nebeneinander an die kathodenseitige Oberfläche des Halbleitersubstrats (14) treten und mit einer darüberliegenden, isolierten Gateelektrode (3) jeweils einen p-Kanal-MOSFET bilden; und
e) zusätzliche Mittel vorgesehen sind, welche das feldeffektgesteuerte Einschalten des Bauelements gewährleisten;
dadurch gekennzeichnet, dass
f) die zusätzlichen Mittel zweite Einheitszellen umfassen, die unabhängig von den ersten Einheitszellen zwischen diesen angeordnet und diesen parallelgeschaltet sind;
g) jede der zweiten Einheitszellen den Aufbau eines bipolaren Transistors mit isoliertem Gate (IGBT = Insulated Gate Bipolar Transistor) aufweist, wobei
h) jede der zweiten Einheitszellen zwischen der Anode (A) und der Kathode (K) eine Schichtfolge aus einer p⁺-dotierten p-Emitterschicht, einer n-dotierten n-Basisschicht und einem in die n-Basisschicht eingelassenen p⁺-dotierten p-Bereich (13) mit seitlich angrenzenden, p-dotierten Kanalgebieten (12) und eingelagerten, n⁺-dotierten Sourcegebieten (11) umfasst;
i) in jeder der zweiten Einheitszellen die Sourcegebiete (11), die Kanalgebiete (12) und die n-Basisschicht nebeneinander an die kathodenseitige Oberfläche des Halbleitersubstrats (14) treten und mit einer darüberliegenden, isolierten Gateelektrode (3) jeweils einen n-Kanal-MOSFET bilden;
k) die Sourcegebiete (11) und der p⁺-Bereich (13) über einen Kathodenkontakt (1) direkt mit der Kathode (K) verbunden sind; und
l) die p-Emitterschichten und die n-Basisschichten beider Einheitszellen jeweils Teil einer sich lateral über das Halbleitersubstrat (14) erstreckenden, gemeinsamen p-Emitterschicht (9) bzw. n-Basisschicht (8) sind.

2. Bauelement nach Anspruch 1, dadurch gekennzeichnet, dass die Schichtfolgen aller Einheitszellen durch ihre komplementären Schichtfolgen ersetzt sind.

3. Bauelement nach Anspruch 1 oder 2, dadurch gekennzeichnet, dass die Gateelektroden (3) aller Einheitszellen auf demselben Potential liegen.

4. Bauelement nach Anspruch 1, dadurch gekennzeichnet, dass die Anzahlen der ersten Einheitszellen und der zweiten Einheitszellen pro Bauelement ungleich sind.

5. Bauelement nach Anspruch 4, dadurch gekennzeichnet, dass das Verhältnis der Anzahl von zweiten Einheitszellen zur Anzahl der ersten Einheitszellen grösser als 2 : 1 ist.

6. Bauelement nach Anspruch 5, dadurch gekennzeichnet, dass dieses Verhältnis etwa 3 : 1 beträgt.

## Claims

1. Power semiconductor component with turn-off facility in which
(a) a plurality of first unit cells is arranged next to each other and connected in parallel in a semiconductor substrate (14) between an anode (A) and a cathode (K);
(b) each of said first unit cells is constructed as an MOS-controlled thyristor (MCT = MOS Controlled Thyristor) which can be turned off by means of a field-effect-controlled short circuit;
(c) each of the first unit cells comprises, between the anode (A) and the cathode (K) a layer sequence composed of a p⁺-doped p-type emitter layer, an n-doped n-type base layer, a p-doped p-type base layer (7) and an n⁺-doped n-type emitter region (6) with laterally adjacent n-doped channel regions (5) and embedded p⁺-doped source regions (4);
(d) in each of the first unit cells, the source regions (4), the channel regions (5) and the p-type base layer (7) emerge next to each other at the cathode-side surface of the semiconductor substrate (14) and in each case form an n-channel MOSFET with an insulated gate electrode (3) situated above it; and
(e) additional means are provided which ensure the field-effect-controlled turning-on of the component;
characterised in that
(f) the additional means comprise second unit cells which, independently of the first unit cells, are arranged between the latter and are connected in parallel with the latter;
(g) each of the second unit cells has the structure of a bipolar transistor with insulated gate (IGBT = Insulated Gate Bipolar Transistor), in which
(h) each of the second unit cells comprises, between the anode (A) and the cathode (K), a layer sequence composed of a p⁺-doped p-type emitter layer, an n-doped n-type base layer, and a p⁺-doped p-type region (13), embedded in the n-type base layer, with laterally adjacent p-doped channel regions (12) and embedded n⁺-doped source regions (11);
(i) in each of the second unit cells, the source regions (11), the channel regions (12) and the n-type base layer emerge next to each other at the cathode-side surface of the semiconductor substrate (14) and in each case form an n-channel MOSFET with an insulated gate electrode (3) situated above it;
(k) the source regions (11) and the p⁺-type region (13) are connected directly to the cathode (K) via a cathode contact (1); and
(l) the p-type emitter layers and the n-type base layers of both unit cells are in each case part of a common p-type emitter layer (9) or n-type base layer (8) respectively extending laterally over the semiconductor substrate (14).

2. Component according to Claim 1, characterised in that the layer sequences of all the unit cells are replaced by their complementary layer sequences.

3. Component according to Claim 1 or 2, characterised in that the gate electrodes (3) of all the unit cells are at the same potential.

4. Component according to Claim 1, characterised in that the numbers of the first unit cells and of the second unit cells per component are unequal.

5. Component according to Claim 4, characterised in that the ratio of the number of second unit cells to the number of the first unit cells is greater than 2 : 1.

6. Component according to Claim 5, characterised in that this ratio is about 3 : 1.

## Revendications

1. Composant à semi-conducteur de puissance blocable dans lequel :
a) dans un substrat de semi-conducteur (14), entre une anode (A) et une cathode (K), sont disposées les unes à côté des autres et connectées en parallèle une pluralité de premières cellules élémentaires;
b) chacune de ces premières cellules élémentaires se présente sous la forme d'un thyristor commandé par MOS (MCT = MOS Controlled Thyristor), qui peut être bloqué via un court-circuit commandé par effet de champ;
c) chacune des premières cellules élémentaires comprend, entre l'anode (A) et la cathode (K), une succession de couches comprenant une couche d'émetteur P à dopage P⁺, une couche de base N à dopage N, une couche de base P (7) à dopage P et une zone d'émetteur N (6) à dopage N⁺ avec des zones de canal (5) à dopage N adjacentes latéralement et des zones de source (4) à dopage P⁺ intercalées;
d) dans chacune des premières cellules élémentaires, les zones de source (4), les zones de canal (5) et la couche de base P (7) sont disposées les unes à côté des autres sur la surface côté cathode du substrat de semi-conducteur (14) et forment avec une électrode de grille isolée superposée (3) respectivement un MOSFET à canal P, et
e) des moyens supplémentaires sont prévus pour assurer l'activation du composant par commande par effet de champ;
caractérisé en ce que :
f) les moyens supplémentaires comprennent des secondes cellules élémentaires qui sont agencées indépendamment des premières cellules élémentaires, entre celles-ci, et sont connectées en parallèle avec celles-ci;
g) chacune des secondes cellules élémentaires présente la structure d'un transistor bipolaire avec une grille isolée (IGBT = Insulated Gate Bipolar Transistor);
h) chacune des secondes cellules élémentaires comprenant, entre l'anode (A) et la cathode (K), une succession de couches comportant une couche d'émetteur P à dopage P⁺, une couche de base N à dopage N et un domaine P (13) à dopage P⁺ encastré dans la couche de base N avec des zones de canal (12) à dopage P adjacentes latéralement et des zones de source (11) à dopage N⁺ intercalées;
i) dans chacune des secondes cellules unitaires, les zones de source (11), les zones de canal (12) et la couche de-base N s'appliquent l'une à côté de l'autre sur la surface côté cathode du substrat de semi-conducteur (14) et forment avec une électrode à grille superposée isolée (3) respectivement un MOSFET à canal N;
k) les zones de source (11) et la zone P⁺ (13) sont reliées directement à la cathode (K) via un contact cathodique (1), et
l) les couches d'émetteur P et les couches de base N des deux cellules unitaires font respectivement partie d'une couche d'émetteur P (9) ou d'une couche de base N (8) commune s'étendant latéralement sur le substrat de semi-conducteur (14).

2. Composant selon la revendication 1, caractérisé en ce que les successions de couches de toutes les cellules unitaires sont remplacées par leurs successions de couches complémentaires.

3. Composant selon la revendication 1 ou 2, caractérisé en ce que les électrodes à grille (3) de toutes les cellules unitaires ont le même potentiel.

4. Composant selon la revendication 1, caractérisé en ce que les nombres de premières cellules unitaires et de secondes cellules unitaires ne sont pas les mêmes pour chaque composant.

5. Composant selon la revendication 4, caractérisé en ce que le rapport du nombre de secondes cellules unitaires au nombre de premières cellules unitaires est supérieur à 2 : 1.

6. Composant selon la revendication 5, caractérisé en ce que ledit rapport est d'environ 3 : 1.
